# EUROPEAN PATENT SPECIFICATION

(11) **EP 3 101 701 B1**
(45) Date of publication and mention of the grant of the patent: **11.09.2019**
(21) Application number: 14880620.1
(22) Date of filing: 29.08.2014
(51) Int. Cl.: H01L 41/047, H01L 41/083, F02M 51/06

(54) **LAMINATED PIEZOELECTRIC ELEMENT, AND INJECTION DEVICE AND FUEL-INJECTION SYSTEM CONTAINING SAID LAMINATED PIEZOELECTRIC ELEMENT**
LAMINIERTES PIEZOELEKTRISCHES ELEMENT SOWIE EINSPRITZVORRICHTUNG UND KRAFTSTOFFEINSPRITZSYSTEM MIT DIESEM LAMINIERTEN PIEZOELEKTRISCHEN ELEMENT
ÉLÉMENT PIÉZOÉLECTRIQUE STRATIFIÉ, ET DISPOSITIF D'INJECTION ET SYSTÈME D'INJECTION DE CARBURANT CONTENANT LEDIT ÉLÉMENT PIÉZOÉLECTRIQUE STRATIFIÉ

(30) Priority: 30.01.2014 JP 2014015700
(43) Date of publication of application: 07.12.2016
(73) Proprietor: Kyocera Corporation, Kyoto-shi, Kyoto 612-8501 (JP)
(72) Inventor: KATO,Takeshi, Kyoto-shi, Kyoto 612-8501 (JP)
(74) Representative: Viering, Jentschura & Partner mbB Patent- und Rechtsanwälte
(86) International application number: PCT/JP2014/072752
(87) International publication number: WO 2015/114866

(56) References cited:
- DE-A1- 19 913 271
- JP-A- 2002 252 386
- JP-A- 2008 010 742
- JP-U- S63 118 252
- JP-U- S63 118 252
- US-A1- 2008 001 503

## Description

### Technical Field

The present invention relates to a multi-layer piezoelectric element according to the preamble of each of claims 1, 3 and 5, used as, for example, a piezoelectric drive element (piezoelectric actuator), a piezoelectric sensor element, a piezoelectric circuit element, and the like, and an injection device and fuel-injection system containing the multi-layer piezoelectric element.

### Background Art

Multi-layer piezoelectric elements having a configuration including a stacked body formed by laminating piezoelectric layers and internal electrode layers together, and an external electrode plate disposed on a side surface of the stacked body and electrically connected to the internal electrode layers via an electrically conductive bonding material are known (e.g. see Patent Document 1).

### Citation List

### Patent Literature

Patent Literature 1: Japanese Unexamined Patent Application Publication No. 2008-10742A

JP 63-118252 U and DE 199 13 271 A1 disclose a multi-layer piezoelectric element according to the initially-mentioned type.

### Summary of Invention

### Technical Problem

Here, with the multi-layer piezoelectric element described in Patent Literature 1, heat is generated at an end of an entrance side of the external electrode plate when rush current enters. Also, heat is generated in the electrically conductive bonding material. Furthermore, there is a problem in that when repeated localized heat generation occurs, the electrically conductive bonding material deteriorates and the holding force thereof declines, leading to the detachment of the external electrode plate. Additionally, due to the difference in thermal expansion between the electrically conductive bonding material and the external electrode plate, there is a possibility that cracking between the electrically conductive bonding material and the external electrode plate will progress to the point that the driving of the multi-layer piezoelectric element comes to a halt.

In light of the problems described above, an object of the invention is to provide a multi-layer piezoelectric element that minimizes detachment of the external electrode plate and suppresses crack formation in the electrically conductive bonding material; and to provide an injection device and a fuel-injection system containing the multi-layer piezoelectric element.

### Solution to Problem

The present invention provides a multi-layer piezoelectric element according to claim 1, a multi-layer piezoelectric element according to claim 3, a multi-layer piezoelectric element according to claim 5, an injection device according to claim 8, and a fuel-injection system according to claim 9. Further embodiments of the present invention are described in the dependent claims.

### Advantageous Effects of Invention

According to the multi-layer piezoelectric element of the invention, an excellent multi-layer piezoelectric element can be obtained whereby detachment of the external electrode plate can be minimized and crack formation in the electrically conductive bonding material can be suppressed; and which can be stably driven over an extended period of time without changing the driving amount.

Additionally, according to the injection device and the fuel-injection system of the invention, desired injection of high-pressure fuel can be stably performed over an extended period of time.

### Brief Description of Drawings

FIG. 1 is a schematic perspective view illustrating an example of an embodiment of a multi-layer piezoelectric element of the invention.
FIG. 2A is a partially omitted schematic vertical cross-section view illustrating an example of the embodiment of the multi-layer piezoelectric element of the invention. FIG. 2B is a schematic front view of the multi-layer piezoelectric element depicted in FIG. 2A.
FIG. 3A is a partially omitted schematic vertical cross-section view illustrating another example of the embodiment of the multi-layer piezoelectric element of the invention. FIG. 3B is a schematic front view of the multi-layer piezoelectric element depicted in FIG. 3A.
FIG. 4A is a partially omitted schematic vertical cross-section view illustrating another example of the embodiment of the multi-layer piezoelectric element of the invention. FIG. 4B is a schematic front view of the multi-layer piezoelectric element depicted in FIG. 4A.
FIG. 5A is a partially omitted schematic vertical cross-section view illustrating another example of the embodiment of the multi-layer piezoelectric element of the invention. FIG. 5B is a schematic front view of the multi-layer piezoelectric element depicted in FIG. 5A.
FIG. 6A is a partially omitted schematic vertical cross-section view illustrating another example of the embodiment of the multi-layer piezoelectric element of the invention. FIG. 6B is a schematic front view of the multi-layer piezoelectric element depicted in FIG. 6A.
FIG. 7 is a schematic cross-section view illustrating an example of an embodiment of an injection device of the invention.
FIG. 8 is a schematic block diagram illustrating an example of an embodiment of a fuel-injection system of the invention.

### Description of Embodiments

Hereinafter, a detailed description of examples of an embodiment of a multi-layer piezoelectric element of the invention is given while referencing the drawings.

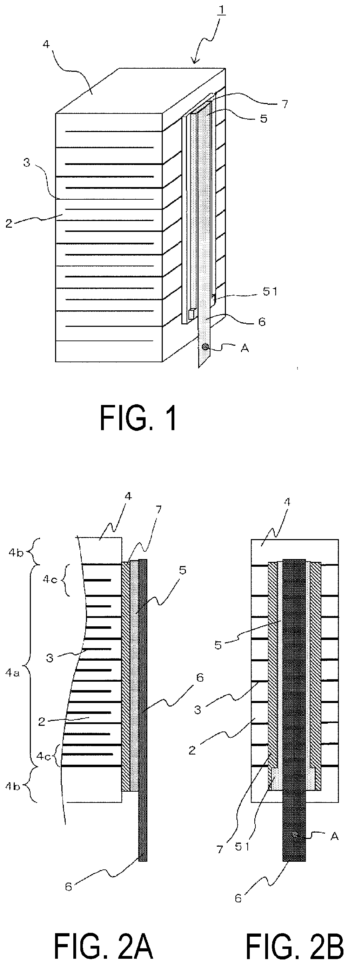

FIG. 1 is a schematic perspective view illustrating an example of an embodiment of the multi-layer piezoelectric element of the invention. FIG. 2A is a partially omitted schematic vertical cross-section view illustrating an example of the embodiment of the multi-layer piezoelectric element of the invention. FIG. 2B is a schematic front view illustrating an example of the embodiment of the multi-layer piezoelectric element depicted in FIG. 2A.

The multi-layer piezoelectric element 1 illustrated in FIG. 1 and FIGS. 2A and 2B includes a stacked body 4 including an active section 4a including piezoelectric layers 2 and internal electrode layers 3 laminated together, and an inactive section 4b located outside the active section 4a in the stacking direction; an electrically conductive bonding material 5 disposed on a side surface of the stacked body 4 parallel to the stacking direction; and an external electrode plate 6 connected to the side surface of the stacked body 4 with the electrically conductive bonding material 5 interposed therebetween. In such a multi-layer piezoelectric element 1, one end of the external electrode plate 6 extends past the electrically conductive bonding material 5 in the stacking direction, and the external electrode plate 6 includes, on this end, an area A connected to an external circuit. The electrically conductive bonding material 5 includes a wider region 51 with a greater width than other regions, at one end thereof closer to the one end than to the other end, both of the external electrode plate 6.

The stacked body 4 constituting the multi-layer piezoelectric element 1 is formed by laminating the piezoelectric layers 2 and the internal electrode layers 3 together. For example, the stacked body 4 includes an active section 4a formed by alternately laminating a plurality of the piezoelectric layers 2 and the internal electrode layers 3, and an inactive section 4b formed by the piezoelectric layers 2 located outside (at both ends in the stacking direction) the active section 4a in the stacking direction. The stacked body 4 is formed, for example, into a rectangular parallelepiped shape having a length of 0.5 to 10 mm, a width of 0.5 to 10 mm, and a height of 5 to 100 mm.

The piezoelectric layers 2 constituting the stacked body 4 are formed from a ceramic having piezoelectric properties. Examples of such a ceramic that can be used include perovskite-type oxides made from lead zirconate titanate (PbZrO₃-PbTiO₃), lithium niobate (LiNbO₃), lithium tantalate (LiTaO₃), and the like. A thickness of each of the piezoelectric layers 2 is, for example, from 3 to 250 µm.

The internal electrode layers 3 constituting the stacked body 4 are formed by firing with the ceramics that forms the piezoelectric layers 2 at the same time. The internal electrode layers 3 are alternately laminated with the piezoelectric layers 2 so as to be over and under the piezoelectric layers 2, and apply driving voltage to the piezoelectric layers 2 sandwiched therebetween due to positive electrodes and negative electrodes being arranged in the lamination order. Examples of materials that can be used for forming the internal electrode layers 3 include electrical conductors having silver-palladium, which has low reactivity with piezoelectric ceramics, as a primary component, or electrical conductors containing copper, platinum, or the like. In the example illustrated in FIG. 1, each of the positive electrodes and the negative electrodes lead out alternately to a pair of opposing side surfaces of the stacked body 4, and are electrically connected to a pair of electrical conductor layers 7 disposed on the side surfaces of the stacked body 4 parallel to the stacking direction. A thickness of each of the internal electrode layers 3 is, for example, from 0.1 to 5 µm.

The pair of electrical conductor layers 7 disposed on the side surfaces of the stacked body 4 parallel to the stacking direction and electrically connected to the internal electrode layers 3 is formed, for example, by applying and firing a paste made from silver and glass. The pair of electrical conductor layers 7 are joined to the side surfaces of the stacked body 4 and are electrically connected to each of the internal electrode layers 3 that lead out alternately to the opposing side surfaces of the stacked body 4. A thickness of the electrical conductor layers 7 is, for example, from 5 to 500 µm.

The external electrode plate 6 is connected to the electrical conductor layers 7 with the electrically conductive bonding material 5 interposed therebetween. The electrically conductive bonding material 5 is preferably a material made from an electrically conductive bonding material 5 made from, for example, an epoxy resin or a polyimide resin containing metal powder with excellent electrical conductivity such as Ag powder, Cu powder, or the like. The electrically conductive bonding material 5 is disposed on the side surface of the stacked body 4 parallel to the stacking direction, and is formed, for example at a thickness of 5 to 500 µm.

In addition to the external electrode plate 6 being electrically connected to the internal electrode layers 3 with the electrically conductive bonding material 5 interposed therebetween, one end thereof extends past the electrically conductive bonding material 5 in the stacking direction. In the multi-layer piezoelectric element 1 illustrated in FIG. 1 and FIGS. 2A and 2B, the external electrode plate 6 is mounted so that the one end thereof extends past the stacked body 4. Note that the one end of the external electrode plate 6 that extends past the stacked body 4 includes an area A to which a lead or the like is joined and is configured to connect to an external circuit via this lead. Additionally, a hatching different from the external electrode plate 6 is intentionally used to clearly depict this area in the drawings, but there is no requirement that this area be specified. That is, it is sufficient that a lead or the like be joined to the one end that extends past the stacked body 4.

The external electrode plate 6 is made from a flat metal plate of copper, iron, stainless steel, phosphor bronze, or the like and is formed, for example, having a width of 0.5 to 10 mm and a thickness of 0.01 to 1.0 mm. The external electrode plate 6 may also be a metal plate machined into, for example, a form having slits in the horizontal direction or a reticulated form, as such forms are highly effective in mitigating stress generated by the expansion and contraction of the stacked body 4.

Furthermore, as illustrated in FIG. 1 and FIGS. 2A and 2B, the one end of the external electrode plate 6 includes an area connected to an external circuit and the electrically conductive bonding material 5 includes a wider region 51 with a greater width than other regions, at one end thereof closer to the one end than to the other end, both of the external electrode plate 6. Due to the electrically conductive bonding material 5 including the wider region with a greater width than other regions at the entrance side of the rush current, that is, at the one end thereof closer to the one end than to the other end, both of the external electrode plate 6, electrical resistance values within this wider region are lower and localized heat generation is suppressed. Accordingly, deterioration of the end of the electrically conductive bonding material 5 caused by repeated heat generation is reduced and detachment of the external electrode plate 6 is suppressed. Additionally, the difference in thermal expansion between the electrically conductive bonding material 5 and the external electrode plate 6 is smaller, and the progression of cracking between the electrically conductive bonding material 5 and the external electrode plate 6 can be suppressed. Note that when a width of the electrically conductive bonding material 5 at a central portion (the other regions) is set to 0.5 to 2.5 mm, a width of the wider region 51 can, for example, be set to 0.6 to 3 mm. A thickness of the electrically conductive bonding material 5 is, for example, from 3 to 50 µm and a length in the stacking direction of the wider region 51 is, for example, from 1 to 6 mm.

As illustrated in FIGS. 2A and 2B, preferably, the external electrode plate 6 and the electrically conductive bonding material 5 are provided across the active section 4a and the inactive section 4b, and the electrically conductive bonding material 5 in the inactive section 4b is configured to be the wider region 51. By configuring the wider region of the electrically conductive bonding material 5 to be provided in this region, which is not prone to being affected by self heating as the inactive section 4b does not self heat, the electrically conductive bonding material 5 will have strong adhesive strength and the external electrode plate 6 will not easily detach.

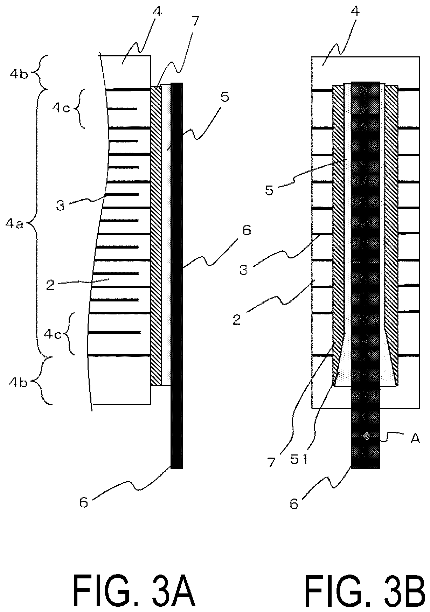

FIG. 3A is a partially omitted schematic vertical cross-section view illustrating another example of an embodiment of the multi-layer piezoelectric element. FIG. 3B is a schematic front view of the multi-layer piezoelectric element depicted in FIG. 3A.

As illustrated in FIGS. 3A and 3B, preferably, a width with the wider region 51 gradually increases as getting farther from the other regions. Because sudden changes in the electrical resistance values are eliminated and stress concentration is not prone to occur, gradually increasing the width of the electrically conductive bonding material 5 as getting farther from the other regions is effective from the perspectives of minimizing detachment of the external electrode plate 6 and suppressing the progression of cracking between the electrically conductive bonding material 5 and the external electrode plate 6.

Additionally, as illustrated in FIGS. 3A and 3B, preferably the thickness of each of the piezoelectric layers 2 in the active section 4a near the boundary with the inactive section 4b gradually increases as getting closer to the inactive section 4b, and a boundary between the wider region 51 and the other regions (narrower regions) of the electrically conductive bonding material 5 is on the piezoelectric layers 2 having an increased thickness. In other words, a starting point where the width of the wider region 51 of the electrically conductive bonding material 5 begins to widen is preferably positioned in the active section 4a near the boundary with the inactive section 4b.

There is a possibility that stress will concentrate at the boundary between the active section 4a, which expands and contracts, and the inactive section 4b, which does not expand and contract, leading to cracks forming in the electrically conductive bonding material 5 in this area, the external electrode plate 6 detaching, and the like. As a countermeasure, the piezoelectric layers 2 in the active section 4a near the boundary with the inactive section 4b can be configured as a region (stress mitigation region 4c) where the thickness of each of the piezoelectric layers 2 gradually increases as getting closer to the inactive section 4b, for the purpose of mitigating stress concentration at the boundary between the active section 4a and the inactive section 4b. In such a case, by positioning the starting point, where the width of the electrically conductive bonding material 5 begins to widen, in the active section near the boundary, the thermal effects on the stress mitigation region 4c can be reduced, stress can be reduced, and detachment of the external electrode plate 6 can be suppressed.

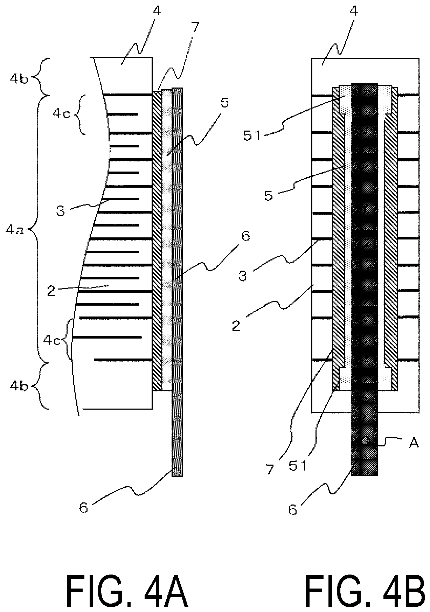

FIG. 4A is a partially omitted schematic vertical cross-section view illustrating another example of an embodiment of the multi-layer piezoelectric element. FIG. 4B is a schematic front view of the multi-layer piezoelectric element depicted in FIG. 4A.

As illustrated in FIGS. 4A and 4B, preferably, the electrically conductive bonding material 5 has a region 51 with a greater width than other regions, at one end thereof closer to the other end than to the said one end, both of the external electrode plate 6. There is a possibility that the end of the electrically conductive bonding material 5 closer to the other end of the external electrode plate 6 will deteriorate due to being subjected to the effects of heat and the external electrode plate 6 will become prone to detachment, due to the fact that heat dissipation from the other end (tip portion) of the external electrode plate 6 is poor. However, by also providing the region 51 with a greater width, at the one end of the electrically conductive bonding material 5 closer to the other end than to the said one end, both of the external electrode plate 6, joint strength increases and, as a result, the external electrode plate 6 will be even less prone to detachment.

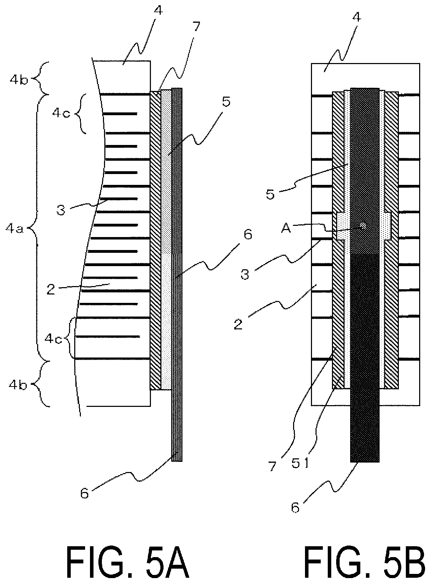

FIG. 5A is a partially omitted schematic vertical cross-section view illustrating another example of an embodiment of the multi-layer piezoelectric element. FIG. 5B is a schematic front view of the multi-layer piezoelectric element depicted in FIG. 5A.

In the multi-layer piezoelectric element illustrated in FIGS. 5A and 5B, an example is depicted in which the external electrode plate 6 includes an area connected to an external circuit, the electrically conductive bonding material 5 includes a wider region with a width greater than the other regions thereof, and the area of the external electrode plate 6 connected to the external circuit is on the wider region of the electrically conductive bonding material 5.

In FIGS. 1A and 1B and FIGS. 2A and 2B, the one end of the external electrode plate 6 extends past the stacked body 4, and an area A where a lead or the like is joined is provided on the extended one end of the external electrode plate 6. In contrast, in FIGS. 5A and 5B, when viewed from the front, the area A is provided on the external electrode plate 6 located inside the stacked body 4.

Furthermore, preferably the electrically conductive bonding material 5 located below the area A of the external electrode plate 6, located inside the stacked body 4 and connected to the external circuit, is configured as the wider region of the electrically conductive bonding material 5. In other words, the rush current entrance, namely, the area A, is preferably provided on the wider region of the electrically conductive bonding material 5. As a result of this configuration, the electrical resistance values in the wider region will be smaller and localized heat generation will be suppressed. Accordingly, deterioration of the electrically conductive bonding material 5 caused by repeated heat generation is reduced and detachment of the external electrode plate 6 is suppressed. Additionally, the difference in thermal expansion between the electrically conductive bonding material 5 and the external electrode plate 6 is smaller, and the progression of cracking between the electrically conductive bonding material 5 and the external electrode plate 6 can be suppressed.

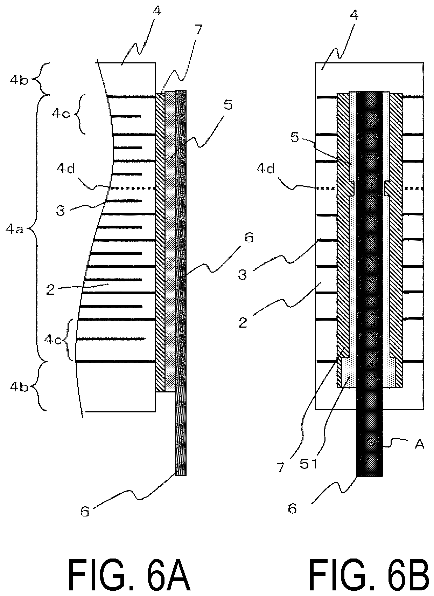

FIG. 6A is a partially omitted schematic vertical cross-section view illustrating another example of an embodiment of the multi-layer piezoelectric element. FIG. 6B is a schematic front view of the multi-layer piezoelectric element depicted in FIG. 6A.

As illustrated in FIGS. 6A and 6B, preferably, a breaking layer 4d, more prone to crack formation due to expansion and contraction of the stacked body 4 than the piezoelectric layers 2 and the internal electrode layers 3, is formed in the active section 4a, and the width of the electrically conductive bonding material 5 located on the breaking layer 4d is the smallest. Note that the breaking layer 4d is intentionally provided so that cracking occurs therein to prevent cracking from occurring in the other areas (e.g. the internal electrode layers 3) and interrupting the driving of the multi-layer piezoelectric element 1. Examples of the breaking layer 4d include metal layers that do not function as an internal electrode layer such as a metal layer having more voids than the internal electrode layers 3, or a layer in which a plurality of metal portions are provided so as to be isolated from each other and scattered. Because cracking is intentionally caused in the breaking layer 4d, a configuration in which the position of the electrically conductive bonding material 5 closer to the breaking layer 4d is the portion where the width of the electrically conductive bonding material 5 narrows is effective from the perspective of weakening the binding force.

Next, a manufacturing method of the multi-layer piezoelectric element 1 according to the embodiment will be described.

First, ceramic green sheets that will become the piezoelectric layers 2 are fabricated. Specifically, a ceramic slurry is formed by mixing a calcined powder of piezoelectric ceramics, a binder made from an acrylic-based, butyral-based, or similar organic polymer, and a plasticizer. Then, the ceramic green sheets are fabricated using this ceramic slurry by utilizing a doctor blade method, a calender roll method, or similar tape molding method. Any piezoelectric ceramics may be used, provided that the piezoelectric ceramics have piezoelectric properties, and examples thereof include, perovskite-type oxides made from lead zirconate titanate (PbZrO₃-PbTiO₃) and the like. Additionally, dibutyl phthalate (DBP), dioctyl phthalate (DOP), or the like may be used as the plasticizer.

Next, an electrically conductive paste that becomes the internal electrode layers 3 is fabricated. Specifically, an electrically conductive paste is fabricated by adding/blending a binder and a plasticizer to a silver-palladium metal powder. This electrically conductive paste is applied in the pattern of the internal electrode layers 3 on the ceramic green sheets using a screen printing method.

In cases where the breaking layer 4d is provided in the stacked body, either resin beads or the like that are lost in firing are included in the electrically conductive paste forming the breaking layer 4d, or the silver ratio, for example, in the electrically conductive paste forming the breaking layer is increased to be greater than in the electrically conductive paste forming the internal electrode layers and diffused therein via firing.

Furthermore, a plurality of the ceramic green sheets on which the electrically conductive paste is printed are laminated and subjected to binder removal treatment at a predetermined temperature. Thereafter, firing at a temperature of 900 to 1,200°C is performed and the resulting products are subjected to grinding processing into a predetermined shape using a surface grinding machine or the like. Thus, the stacked body 4 in which the piezoelectric-body layers 2 and the internal electrode layers 3 are alternately laminated is fabricated.

Note that the stacked body 4 is not limited to products fabricated according to the manufacturing method described above and, provided that the stacked body 4 formed by laminating a plurality of the piezoelectric layers 2 and the internal electrode layers 3 together can be fabricated, any manufacturing method may be used to fabricate the stacked body 4.

Thereafter, a silver glass-containing electrically conductive paste produced by adding a binder, a plasticizer, and a solvent to a mixture of electrically conductive particles having silver as a primary component and glass, is printed on the side surfaces of the stacked body 4 in the pattern of the electrical conductor layers 7 using a screen printing method or the like. Then, after drying, the resulting product is subjected to baking at a temperature of 650 to 750°C. Thus, the electrical conductor layers 7 are formed.

Next, the external electrode plate 6 is connected and fixed to the surface of the electrical conductor layers 7 with the electrically conductive bonding material 5 interposed therebetween.

An electrically conductive bonding material paste made from an epoxy resin or a polyimide resin containing metal powder with excellent electrical conductivity such as Ag powder, Cu powder, or the like is used for the electrically conductive bonding material 5, and the electrically conductive bonding material 5 can be formed so as to be restrained to a predetermined thickness and width by using a dispensing system.

The width of the electrically conductive bonding material 5 can be adjusted by changing the gap between the dispenser and the stacked body 4, changing the number of application passes such that wide portions are applied in two passes and narrow portions are applied in one pass, and the like.

The external electrode plate 6 is a flat metal plate of copper, iron, stainless steel, phosphor bronze, or the like and is formed, for example, having a width of 0.5 to 10 mm and a thickness of 0.01 to 1.0 mm. The external electrode plate 6 may also be subjected to processing such as punching or laser machining into, for example, a form having slits in the horizontal direction or a reticulated form, as such forms are highly effective in mitigating stress generated by the expansion and contraction of the stacked body 4.

Then, a direct electric field of 0.1 to 3 kV/mm is applied to the external electrode plate 6 connected to each of the pair of electrical conductor layers 7, and the piezoelectric layers 2 constituting the stacked body 4 are polarized. Thus, the multi-layer piezoelectric element 1 is completed. With this multi-layer piezoelectric element 1, by connecting the electrical conductor layers 7 and an external power supply together via the external electrode plate 6 and applying voltage to the piezoelectric layers 2, each of the piezoelectric layers 2 can be greatly displaced due to the inverse piezoelectric effect. As a result, it is possible to cause the multi-layer piezoelectric element 1 to function as, for example, a fuel injection valve for an automobile that injects/supplies fuel to an engine.

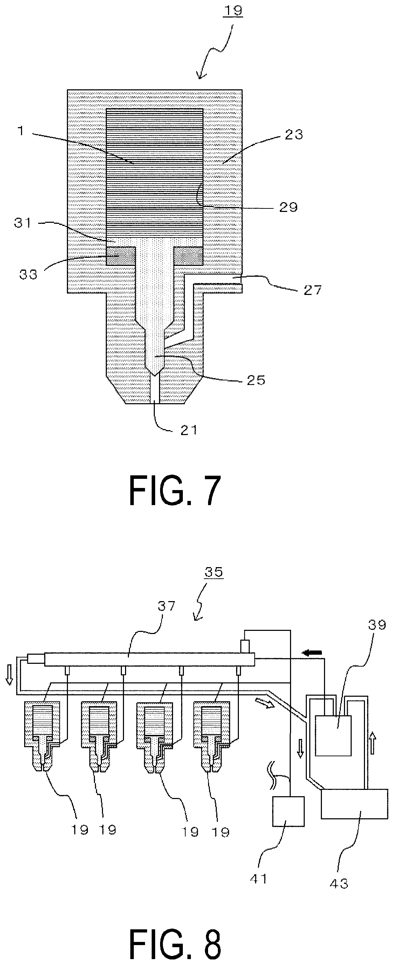

Next, an example of an embodiment of the injection device of the invention is described. FIG. 7 is a schematic cross-section view illustrating an example of an embodiment of the injection device of the invention.

As illustrated in FIG. 7, the injection device 19 of the embodiment is constituted by a housing container (container) 23 including an injection hole 21 at one end thereof, and the multi-layer piezoelectric element 1 of the embodiment described above is contained inside the housing container 23.

A needle valve 25 capable of opening and closing the injection hole 21 is provided in the housing container 23. A fluid passage 27 is provided in the injection hole 21 that is capable of communication with the injection hole 21 depending on movement of the needle valve 25. The fluid passage 27 is connected to an external fluid supply source, which supplies fluid at constant high pressure to the fluid passage 27. Thus, the injection device 19 is configured so that, when the needle valve 25 opens the injection hole 21, the fluid supplied to the fluid passage 27 is discharged out or into an adjacent container, for example, a combustion chamber of an internal combustion engine (not illustrated in the drawings), from the injection hole 21.

Additionally, the diameter of an upper end portion of the needle valve 25 is larger and constitutes a piston 31 that is slideable in a cylinder 29 formed in the housing container 23. Moreover, the multi-layer piezoelectric element 1 of the example described above is contained in the housing container 23 in contact with the piston 31.

In the injection device 19 described above, when voltage is applied and the multi-layer piezoelectric element 1 elongates, pressure is applied to the piston 31 and the needle valve 25 closes the fluid passage 27 that communicates with the injection hole 21. Thus, the supply of fluid is halted. Additionally, the injection device 19 is configured so that when the application of voltage is halted, the multi-layer piezoelectric element 1 contracts, a plate spring 33 pushes the piston 31 back, the fluid passage 27 is opened, the injection hole 21 communicates with the fluid passage 27, and the fluid is sprayed from the injection hole 21.

Note that the injection device 19 may be configured so that the fluid passage 27 opens when voltage is applied to the multi-layer piezoelectric element 1 and the fluid passage 27 closes when the application of voltage is halted.

Additionally, the injection device 19 of the embodiment may be configured to include a container 23 including an injection hole and the multi-layer piezoelectric element 1 of the embodiment, wherein the fluid filling the container 23 is discharged from the injection hole 21 by driving of the multi-layer piezoelectric element 1. That is, it is not necessary for the multi-layer piezoelectric element 1 to be inside the container 23 and any configuration is possible provided that pressure is applied to the inside of the container 23, to control the injection of the fluid, by the driving of the multi-layer piezoelectric element 1. Note that in the injection device 19 of the embodiment, the term "fluid" should be construed to include various types of liquids such as electrically conductive paste and the like and also gases, in addition to fuel, ink, and the like. By using the injection device 19 of the embodiment, the flow rate and spray timing of the fluid can be stably controlled over an extended period of time.

By using the injection device 19 of the embodiment utilizing the multi-layer piezoelectric element 1 of the embodiment in an internal combustion engine, compared to conventional injection devices, the injection device 19 can be made to inject fuel into the combustion chamber of an internal combustion engine such as an engine with high precision over an extended period of time.

Next, an example of an embodiment of the fuel-injection system of the invention is described. FIG. 8 is a schematic diagram illustrating an example of an embodiment of the fuel-injection system of the invention.

As illustrated in FIG. 8, a fuel-injection system 35 of the embodiment includes a common rail 37 configured to store high-pressure fuel as a high-pressure fluid, a plurality of the injection devices 19 of the embodiment configured to inject the high-pressure fluid stored in the common rail 37, a pressure pump 39 configured to supply the high-pressure fluid to the common rail 37, and an injection control unit 41 configured to provide driving signals to the injection device 19.

The injection control unit 41 controls an amount and timing of the injection of the high-pressure fluid on the basis of external information or signals from external sources. For example, in cases where the injection control unit 41 is used for fuel injection in an engine, the amount and timing of fuel injection can be controlled while using a sensor or the like to sense the condition within the combustion chamber of the engine. The pressure pump 39 serves a role of supplying fluid fuel from a fuel tank 43 to the common rail 37 at high pressure. For example, in a case of the fuel-injection system 35 of an engine, fluid fuel is pumped to the common rail 37 at high pressures of, for example, from 1000 to 2000 atmospheres (about 101 MPa to about 203 MPa), and preferably from 1500 to 1700 atmospheres (about 152 MPa to about 172 MPa). The high-pressure fuel supplied from the pressure pump 39 is stored in the common rail 37 and pumped appropriately to the injection device 19. As described previously, the injection device 19 sprays the prescribed fluid out or into an adjacent container from the injection hole 21. For example, in cases where an engine is the target of the injection/supplying of fuel, a high-pressure fuel is sprayed as a mist from the injection hole 21 into the combustion chamber of the engine.

The invention is not limited to the above-described embodiments, and various modifications and the like may be made without departing from the scope of the invention. For example, in the example of the embodiment described above, the shape of a cross-section in a direction orthogonal to the stacking direction of the stacked body 4 is rectangular, but may also be polygonal such as hexagonal, octagonal, or the like, round, or a shape having a combination of straight lines and arcs.

The multi-layer piezoelectric element 1 of the embodiment can be used as, for example, a piezoelectric driving element (piezoelectric actuator), a piezoelectric sensor element, a piezoelectric circuit element, and the like. Examples of driving elements include fuel injection devices of automotive engines, ink jet and similar liquid discharging devices, optical devices such as precision positioning devices, and vibration preventing devices. Examples of sensor elements include combustion pressure sensors, knock sensors, acceleration sensors, load sensors, ultrasonic sensors, pressure-sensitive sensors, and yaw rate sensors. Examples of circuit elements include piezoelectric gyros, piezoelectric switches, piezoelectric transformers, and piezoelectric breakers.

### Examples

A piezoelectric actuator provided with a multi-layer piezoelectric element was fabricated as described below. First, a calcined powder of piezoelectric ceramics having lead zirconate titanate (PbZrO₃-PbTiO₃) with an average particle size of 0.4 µm as a primary component, a binder, and a plasticizer were blended. Thus, a ceramic slurry was obtained. Then, using this ceramic slurry, ceramic green sheets of a thickness of 50 µm that would become the piezoelectric layers were fabricated via a doctor blade method.

Then, a binder was added to silver-palladium and an electrically conductive paste that would become the internal electrode layers was fabricated.

Next, the electrically conductive paste that would become the internal electrode layers was printed via a screen printing method on one side of the ceramic green sheets, and 200 of the ceramic green sheets, on which the electrically conductive paste was printed, were laminated together. Additionally, a total of 15 ceramic green sheets, on which the electrically conductive paste that would become the internal electrode layers was not printed, were laminated on top of and under the body of 200 ceramic green sheets, on which the electrically conductive paste that would become the internal electrode layers was printed. Then, firing at 980 to 1100°C was performed and the resulting product was ground into a predetermined shape using a surface grinding machine. Thus, a stacked body with a 5 mm square end face was obtained.

Next, an electrically conductive paste formed by mixing a binder with silver and glass was printed, via a screen printing method, on a side surface of the stacked body, namely at forming portions of the electrical conductor layers, and was subjected to firing treatment at 700°C. Thus, the electrically conductive layers were formed.

Next, an electrically conductive adhesive constituted by a paste-like mixture of Ag powder and polyimide resin was applied to a front surface of the electrical conductor layers and the external electrode plate was attached and affixed thereto in a manner parallel to the front surface of the stacked body. Note that the external electrode plate was fixed so that one end thereof extended past the stacked body.

An external electrode plate, where the electrically conductive bonding material includes a wider region with a greater width than other regions, at one end thereof closer to the one end than to the other end, both of the external electrode plate, was used as a Sample 1. Specifically, the other regions, namely the central portion, had a width of 1.2 mm, the wider region had a width of 2.2 mm, the stacking direction length of the wider region was 3 mm, and the thickness of the electrically conductive bonding material was 20 µm.

An external electrode plate, where the wider region of the electrically conductive bonding material was the electrically conductive bonding material in the inactive section, was used as a Sample 2.

An external electrode plate, where a width of the wider region of the electrically conductive bonding material gradually increased as getting farther from the other regions, was used as a Sample 3.

An external electrode plate, where the thickness of each of the piezoelectric layers in the active section near the boundary with the inactive section gradually increased as getting closer to the inactive section, and a boundary between the wider region and the other regions of the electrically conductive bonding material was on the piezoelectric layers having an increased thickness, was used as a Sample 4.

An external electrode plate, where a breaking layer, more prone to crack formation due to expansion and contraction of the stacked body than the piezoelectric layers and the internal electrode layers, was formed in the active section, and the width of the electrically conductive bonding material located on the breaking layer was the smallest, was used as a Sample 5. The width of the electrically conductive bonding material located on the breaking layer was 0.8 mm, and the width at other locations was 1.2 mm.

An external electrode plate, where the electrically conductive bonding material includes a region with a width greater than other regions, at one end thereof closer to the other end than to the one end, both of the external electrode plate, was used as a Sample 6. The width of the wider region was 2.2 mm, and the width of the other regions was 1.2 mm.

Additionally, an external electrode plate, where the width of the electrically conductive bonding material was constant throughout, was used as a Comparative Example. The thickness throughout was 20 µm, and the width throughout was 1.2 mm.

These multi-layer piezoelectric elements were subjected to polarization treatment by applying a direct electric field of 3kV/mm for 15 minutes to the external electrode plate via a lead member welded and connected to the external electrode plate. Upon the application of 160 V of direct current voltage to the multi-layer piezoelectric elements, displacement in an amount of 30 µm in the stacking direction of the stacked body was obtained. Furthermore, 0 V to 160 V of alternating current was applied at a frequency of 150 Hz in a 30°C, 90% humidity environment, and a durability test for continuous driving was performed.

As a result, with the multi-layer piezoelectric element of the Comparative Example, cracking occurred in the stacked body at 1 × 10⁴ continuous drives and the driving thereof halted.

In contrast, with the multi-layer piezoelectric element of Samples 1 and 2, driving did not halt even after 1 × 10⁷ continuous drives and, while fine cracking occurred in the electrically conductive bonding material, the external electrode plate did not detach. Additionally, with the multi-layer piezoelectric elements of Samples 3 and 4, no cracking occurred even after 1 × 10⁷ continuous drives. Moreover, no changes in the amount of driving were observed and not even fine cracks were found in the electrically conductive bonding material. Furthermore, with the multi-layer piezoelectric elements of Samples 5 and 6, no cracking occurred even after 1 × 10⁹ continuous drives and no changes in the amount of driving were observed. Additionally, occurrences of fine cracks even in the electrically conductive bonding material were not found and there were no occurrences of the external electrode plate detaching. Note that the durability testing was continued for Sample 5 until breakdown, and the point of origin of the breakdown was the breaking layer.

### Reference Signs List

- 1: Multi-layer piezoelectric element
- 2: Piezoelectric layer
- 3: Internal electrode layer
- 4: Stacked body
- 4a: Active section
- 4b: Inactive section
- 4c: Stress mitigation region
- 4d: Easily breaking layer
- 5: Electrically conductive bonding material
- 51: Wider region
- 6: External electrode plate
- 7: Electrical conductor layer
- 19: Injection device
- 21: Injection hole
- 23: Housing container (container)
- 25: Needle valve
- 27: Fluid passage
- 29: Cylinder
- 31: Piston
- 33: Plate spring
- 35: Fuel-injection system
- 37: Common rail
- 39: Pressure pump
- 41: Injection control unit
- 43: Fuel tank

## Claims

1. A multi-layer piezoelectric element (1) comprising:
a stacked body (4) comprising:
an active section (4a) comprising piezoelectric layers (2) and internal electrode layers (3) laminated together, and
an inactive section (4b) located outside the active section (4a) in a stacking direction;
an electrically conductive bonding material (5) disposed on a side surface of the stacked body (4) parallel to the stacking direction; and
an external electrode plate (6) connected to the side surface of the stacked body (4) with the electrically conductive bonding material (5) interposed therebetween; wherein
the external electrode plate (6) comprises:
one end extending past the electrically conductive bonding material (5) in the stacking direction, and
an area (A) connected to an external circuit on the one end; and
**characterized in that**
the electrically conductive bonding material (5) comprises a wider region (51) with a greater width than other regions of the electrically conductive bonding material (5), at one end thereof closer to the one end of the external electrode plate (6) than to the other end,
wherein:
a thickness of each of the piezoelectric layers (2) in the active section (4a) near a boundary with the inactive section (4b) gradually increases as getting closer to the inactive section (4b); and
a boundary between the wider region (51) and the other regions of the electrically conductive bonding material (5) is on the piezoelectric layers (2) having an increased thickness.

2. The multi-layer piezoelectric element (1) according to claim 1, further comprising:
a breaking layer (4d), more prone to crack formation due to expansion and contraction of the stacked body (4) than the piezoelectric layers (2) and the internal electrode layers (3), is formed in the active section (4a),
wherein the width of the electrically conductive bonding material (5) located on the breaking layer (4d) is the smallest.

3. A multi-layer piezoelectric element (1) comprising:
a stacked body (4) comprising:
an active section (4a) comprising piezoelectric layers (2) and internal electrode layers (3) laminated together, and
an inactive section (4b) located outside the active section (4a) in a stacking direction;
an electrically conductive bonding material (5) disposed on a side surface of the stacked body (4) parallel to the stacking direction; and
an external electrode plate (6) connected to the side surface of the stacked body (4) with the electrically conductive bonding material (5) interposed therebetween; wherein
the external electrode plate (6) comprises:
one end extending past the electrically conductive bonding material (5) in the stacking direction, and
an area (A) connected to an external circuit on the one end,
**characterized in that**
the electrically conductive bonding material (5) comprises a wider region (51) with a greater width than other regions, at one end thereof closer to the one end of the external electrode plate (6) than to the other end,
wherein the multi-layer piezoelectric element (1) further comprises:
a breaking layer (4d), more prone to crack formation due to expansion and contraction of the stacked body (4) than the piezoelectric layers (2) and the internal electrode layers (3), is formed in the active section (4a),
wherein the width of the electrically conductive bonding material (5) located on the breaking layer (4d) is the smallest.

4. The multi-layer piezoelectric element (1) according to any one of claims 1 to 3, wherein:
the electrically conductive bonding material (5) comprises a region with a width greater than other regions, at one end thereof closer to the other end of the external electrode plate (6) than to the said one end.

5. A multi-layer piezoelectric element (1) comprising:
a stacked body (4) comprising:
an active section (4a) comprising piezoelectric layers (2) and internal electrode layers (3) laminated together, and
an inactive section (4b) located outside the active section (4a) in a stacking direction;
an electrically conductive bonding material (5) disposed on a side surface of the stacked body (4) parallel to the stacking direction; and
an external electrode plate (6) connected to the side surface of the stacked body (4) with the electrically conductive bonding material (5) interposed therebetween; wherein
the external electrode plate (6) comprises an area (A) connected to an external circuit,
**characterized in that**
the electrically conductive bonding material (5) comprises a wider region (51) with a width greater than the other regions thereof; and
the area (A) of the external electrode plate (6) connected to the external circuit is positioned on the wider region (51) of the electrically conductive bonding material (5),
wherein the multi-layer piezoelectric element (1) further comprises:
a breaking layer (4d), more prone to crack formation due to expansion and contraction of the stacked body (4) than the piezoelectric layers (2) and the internal electrode layers (3), is formed in the active section (4a),
wherein the width of the electrically conductive bonding material (5) located on the breaking layer (4d) is the smallest.

6. The multi-layer piezoelectric element (1) according to any one of claims 1 to 5, wherein:
the electrically conductive bonding material (5) is provided across the active section (4a) and the inactive section (4b); and
the electrically conductive bonding material (5) in the inactive section (4b) is the wider region (51).

7. The multi-layer piezoelectric element (1) according to any one of claims 1 to 6, wherein:
a width with the wider region (51) gradually increases as getting farther from the other regions.

8. An injection device (19) comprising:
a container (23) comprising an injection hole (21); and
the multi-layer piezoelectric element (1) according to any one of claims 1 to 7, wherein
the injection device (19) is configured to discharge a fluid stored within the container (23) through the injection hole (21) by driving the multi-layer piezoelectric element (1).

9. A fuel-injection system (35) comprising:
a common rail (37) configured to store high-pressure fuel;
the injection device (8) according to claim 8 configured to inject the high-pressure fuel stored in the common rail (37);
a pressure pump (39) configured to supply the high-pressure fuel to the common rail (37); and
an injection control unit (41) configured to send driving signals to the injection device (8).

## Patentansprüche

1. Ein Mehrschicht- piezoelektrisches Element (1), aufweisend:
einen Stapelkörper (4), aufweisend:
einen aktiven Abschnitt (4a), der piezoelektrische Schichten (2) und innere Elektrodenschichten (3) aufweist, die zusammenlaminiert sind, und
einen inaktiven Abschnitt (4b), der in einer Stapelrichtung außerhalb des aktiven Abschnitts (4a) angeordnet ist,
ein elektrisch leitfähiges Verbindungsmaterial (5), das auf einer Seitenfläche des Stapelkörpers (4) parallel zu der Stapelrichtung angeordnet ist, und
eine externe Elektrodenplatte (6), die mit der Seitenfläche des Stapelkörpers (4) verbunden ist, wobei das elektrisch leitfähige Verbindungsmaterial (5) dazwischen angeordnet ist, wobei
die externe Elektrodenplatte (6) aufweist:
ein Ende, das sich in der Stapelrichtung über das elektrisch leitfähige Verbindungsmaterial (5) hinaus erstreckt, und
einen Bereich (A) an dem einem Ende, der mit einer externen Schaltung verbunden ist, und
**dadurch gekennzeichnet, dass**
das elektrisch leitfähige Verbindungsmaterial (5) einen breiteren Bereich (51) mit einer größeren Breite als andere Bereiche des elektrisch leitfähigen Verbindungsmaterials (5) aufweist, an einem Ende davon näher bei dem einen Ende der externen Elektrodenplatte (6) als bei dem anderen Ende,
wobei:
eine Dicke von jeder der piezoelektrischen Schichten (2) im aktiven Abschnitt (4a) nahe bei einer Grenze zu dem inaktiven Abschnitt (4b) während einer Annäherung an den inaktiven Abschnitt (4b) allmählich zunimmt, und
eine Grenze zwischen dem breiteren Bereich (51) und den anderen Bereichen des elektrisch leitfähigen Verbindungsmaterials (5) auf den piezoelektrischen Schichten (2) mit einer größeren Dicke ist.

2. Das Mehrschicht- piezoelektrische Element (1) gemäß Anspruch 1, ferner aufweisend:
eine Brechschicht (4d), die anfälliger für eine Rissbildung durch Expansion und Kontraktion des Stapelkörpers (4) als die piezoelektrischen Schichten (2) und die inneren Elektrodenschichten (3) ist, die im aktiven Abschnitt (4a) ausgebildet ist,
wobei die Breite des elektrisch leitfähigen Verbindungsmaterials (5), das sich auf der Brechschicht (4d) befindet, am geringsten ist.

3. Ein Mehrschicht- piezoelektrisches Element (1), aufweisend:
einen Stapelkörper (4), aufweisend:
einen aktiven Abschnitt (4a), der piezoelektrische Schichten (2) und innere Elektrodenschichten (3) aufweist, die zusammenlaminiert sind, und
einen inaktiven Abschnitt (4b), der in einer Stapelrichtung außerhalb des aktiven Abschnitts (4a) angeordnet ist,
ein elektrisch leitfähiges Verbindungsmaterial (5), das auf einer Seitenfläche des Stapelkörpers (4) parallel zu der Stapelrichtung angeordnet ist, und
eine externe Elektrodenplatte (6), die mit der Seitenfläche des Stapelkörpers (4) verbunden ist, wobei das elektrisch leitfähige Verbindungsmaterial (5) dazwischen angeordnet ist, wobei
die externe Elektrodenplatte (6) aufweist:
ein Ende, das sich in der Stapelrichtung über das elektrisch leitfähige Verbindungsmaterial (5) hinaus erstreckt, und
einen Bereich (A) an dem einem Ende, der mit einer externen Schaltung verbunden ist,
**dadurch gekennzeichnet, dass**
das elektrisch leitfähige Verbindungsmaterial (5) einen breiteren Bereich (51) mit einer größeren Breite als andere Bereiche aufweist, an einem Ende davon näher bei dem einen Ende der externen Elektrodenplatte (6) als bei dem anderen Ende,
wobei das Mehrschicht- piezoelektrische Element (1) ferner aufweist:
eine Brechschicht (4d), die anfälliger für eine Rissbildung aufgrund von Expansion und Kontraktion des Stapelkörpers (4) als die piezoelektrischen Schichten (2) und die inneren Elektrodenschichten (3) ist, die im aktiven Abschnitt (4a) ausgebildet ist,
wobei die Breite des elektrisch leitfähigen Verbindungsmaterials (5), das sich auf der Brechschicht (4d) befindet, am geringsten ist.

4. Das Mehrschicht- piezoelektrische Element (1) gemäß irgendeinem der Ansprüche 1 bis 3, wobei:
das elektrisch leitfähige Verbindungsmaterial (5) einen Bereich mit einer Breite aufweist, die größer als andere Bereiche ist, an einem Ende davon näher bei dem anderen Ende der externen Elektrodenplatte (6) als bei dem einen Ende.

5. Ein Mehrschicht- piezoelektrisches Element (1), aufweisend:
einen Stapelkörper (4), aufweisend:
einen aktiven Abschnitt (4a), der piezoelektrische Schichten (2) und innere Elektrodenschichten (3) aufweist, die zusammenlaminiert sind, und
einen inaktiven Abschnitt (4b), der in einer Stapelrichtung außerhalb des aktiven Abschnitts (4a) angeordnet ist,
ein elektrisch leitfähiges Verbindungsmaterial (5), das auf einer Seitenfläche des Stapelkörpers (4) parallel zu der Stapelrichtung angeordnet ist, und
eine externe Elektrodenplatte (6), die mit der Seitenfläche des Stapelkörpers (4) verbunden ist, wobei das elektrisch leitfähige Verbindungsmaterial (5) dazwischen angeordnet ist, wobei
die externe Elektrodenplatte (6) einen Bereich (A) aufweist, der mit einer externen Schaltung verbunden ist,
**dadurch gekennzeichnet, dass**
das elektrisch leitfähige Verbindungsmaterial (5) einen breiteren Bereich (51) mit einer Breite aufweist, die größer als die anderen Bereiche davon ist, und
der Bereich (A) der externen Elektrodenplatte (6), der mit der externen Schaltung verbunden ist, auf dem breiteren Bereich (51) des elektrisch leitfähigen Verbindungsmaterials (5) positioniert ist,
wobei das Mehrschicht- piezoelektrische Element (1) ferner aufweist:
eine Brechschicht (4d), die anfälliger für eine Rissbildung aufgrund von Expansion und Kontraktion des Stapelkörpers (4) als die piezoelektrischen Schichten (2) und die internen Elektrodenschichten (3) ist, die im aktiven Abschnitt (4a) ausgebildet ist,
wobei die Breite des elektrisch leitfähigen Verbindungsmaterials (5), das sich auf der Brechschicht (4d) befindet, am geringsten ist.

6. Das Mehrschicht- piezoelektrische Element (1) gemäß irgendeinem der Ansprüche 1 bis 5, wobei:
das elektrisch leitfähige Verbindungsmaterial (5) über den aktiven Abschnitt (4a) und den inaktiven Abschnitt (4b) vorgesehen ist, und
das elektrisch leitfähige Verbindungsmaterial (5) im inaktiven Abschnitt (4b) der breitere Bereich (51) ist.

7. Das Mehrschicht- piezoelektrische Element (1) gemäß irgendeinem der Ansprüche 1 bis 6, wobei:
eine Breite mit dem breiteren Bereich (51) bei einem Entfernen von den anderen Bereichen allmählich zunimmt.

8. Eine Einspritzvorrichtung (19), aufweisend:
einen Behälter (23), der ein Einspritzloch (21) aufweist, und
das Mehrschicht- piezoelektrische Element (1) gemäß irgendeinem der Ansprüche 1 bis 7, wobei
die Einspritzvorrichtung (19) konfiguriert ist, um ein im Behälter (23) gespeichertes Fluid durch Ansteuern/Antreiben des Mehrschicht- piezoelektrischen Elements (1) durch das Einspritzloch (21) hindurch auszustoßen.

9. Ein Kraftstoffeinspritzsystem (35), aufweisend:
ein Common Rail (37), das konfiguriert ist, um Hochdruckkraftstoff zu speichern,
die Einspritzvorrichtung (8) gemäß Anspruch 8, die konfiguriert ist, um den in dem Common Rail (37) gespeicherten Hochdruckkraftstoff einzuspritzen,
eine Druckpumpe (39), die konfiguriert ist, um den Hochdruckkraftstoff dem Common Rail (37) zuzuführen, und
eine Einspritzsteuereinheit (41), die konfiguriert ist, um Ansteuer-/Antriebssignale an die Einspritzvorrichtung (8) zu senden.

## Revendications

1. Un élément piézoélectrique multicouche (1), comprenant :
un corps empilé (4), comprenant :
une section active (4a) comprenant des couches piézoélectriques (2) et des couches d'électrodes internes (3) laminées ensemble, et
une section inactive (4b) située à l'extérieur de la section active (4a) dans une direction d'empilement,
un matériau de liaison électriquement conducteur (5) disposé sur une surface latérale du corps empilé (4) parallèlement à la direction d'empilement, et
une plaque d'électrode externe (6) reliée à la surface latérale du corps empilé (4) avec le matériau de liaison électriquement conducteur (5) interposé entre celles-ci, dans lequel
la plaque d'électrode externe (6) comprend :
une extrémité s'étendant au-delà du matériau de liaison électriquement conducteur (5) dans la direction d'empilement, et
une zone (A) connectée à un circuit externe à ladite une extrémité, et
**caractérisé en ce que**
le matériau de liaison électriquement conducteur (5) comprend une région plus large (51) avec une largeur plus grande que d'autres régions du matériau de liaison électriquement conducteur (5), à une extrémité de celui-ci plus proche de ladite une extrémité de la plaque d'électrode externe (6) que de l'autre extrémité,
où :
une épaisseur de chacune des couches piézoélectriques (2) dans la section active (4a) près d'une limite avec la section inactive (4b) augmente progressivement à mesure que l'on se rapproche de la section inactive (4b), et
une limite entre la région plus large (51) et les autres régions du matériau de liaison électriquement conducteur (5) se trouve sur les couches piézoélectriques (2) présentant une épaisseur accrue.

2. L'élément piézoélectrique multicouche (1) selon la revendication 1, comprenant en outre :
une couche de rupture (4d), plus sujette à la formation de fissures dues à l'expansion et à la contraction du corps empilé (4) que les couches piézoélectriques (2) et les couches d'électrodes internes (3), qui est formée dans la section active (4a),
dans lequel la largeur du matériau de liaison électriquement conducteur (5) situé sur la couche de rupture (4d) est la plus petite.

3. Un élément piézoélectrique multicouche (1), comprenant :
un corps empilé (4) comprenant :
une section active (4a) comprenant des couches piézoélectriques (2) et des couches d'électrodes internes (3) laminées ensemble, et
une section inactive (4b) située à l'extérieur de la section active (4a) dans une direction d'empilement,
un matériau de liaison électriquement conducteur (5) disposé sur une surface latérale du corps empilé (4) parallèlement à la direction d'empilement, et
une plaque d'électrode externe (6) reliée à la surface latérale du corps empilé (4) avec le matériau de liaison électriquement conducteur (5) interposé entre celles-ci, dans lequel
la plaque d'électrode externe (6) comprend :
une extrémité s'étendant au-delà du matériau de liaison électriquement conducteur (5) dans la direction d'empilement, et
une zone (A) reliée à un circuit externe à ladite une extrémité,
**caractérisé en ce que**
le matériau de liaison électriquement conducteur (5) comprend une région plus large (51) avec une largeur plus grande que d'autres régions, à une extrémité de celui-ci plus proche de ladite une extrémité de la plaque d'électrode externe (6) que de l'autre extrémité,
dans lequel l'élément piézoélectrique multicouche (1) comprend en outre :
une couche de rupture (4d), plus sujette à la formation de fissures dues à l'expansion et à la contraction du corps empilé (4) que les couches piézoélectriques (2) et les couches d'électrodes internes (3), qui est formée dans la section active (4a),
dans lequel la largeur du matériau de liaison électriquement conducteur (5) situé sur la couche de rupture (4d) est la plus petite.

4. L'élément piézoélectrique multicouche (1) selon l'une quelconque des revendications 1 à 3, dans lequel :
le matériau de liaison électriquement conducteur (5) comprend une région présentant une largeur supérieure à celle d'autres régions, à une extrémité de celui-ci plus proche de l'autre extrémité de la plaque d'électrode externe (6) que de ladite une extrémité.

5. Un élément piézoélectrique multicouche (1), comprenant :
un corps empilé (4), comprenant :
une section active (4a) comprenant des couches piézoélectriques (2) et des couches d'électrodes internes (3) laminées ensemble, et
une section inactive (4b) située à l'extérieur de la section active (4a) dans une direction d'empilement,
un matériau de liaison électriquement conducteur (5) disposé sur une surface latérale du corps empilé (4) parallèlement à la direction d'empilement, et
une plaque d'électrode externe (6) reliée à la surface latérale du corps empilé (4) avec le matériau de liaison électriquement conducteur (5) interposé entre celles-ci, dans lequel
la plaque d'électrode externe (6) comprend une zone (A) reliée à un circuit externe,
**caractérisé en ce que**
le matériau de liaison électriquement conducteur (5) comprend une région plus large (51) avec une largeur supérieure aux autres régions de celui-ci, et
la zone (A) de la plaque d'électrode externe (6) reliée au circuit externe est positionnée sur la zone plus large (51) du matériau de liaison électriquement conducteur (5),
dans lequel l'élément piézoélectrique multicouche (1) comprend en outre :
une couche de rupture (4d), plus sujette à la formation de fissures dues à l'expansion et à la contraction du corps empilé (4) que les couches piézoélectriques (2) et les couches d'électrodes internes, qui est formée dans la section active (4a),
dans lequel la largeur du matériau de liaison électriquement conducteur (5) situé sur la couche de rupture (4d) est la plus petite.

6. L'élément piézoélectrique multicouche (1) selon l'une quelconque des revendications 1 à 5, dans lequel :
le matériau de liaison électriquement conducteur (5) est prévu à travers la section active (4a) et la section inactive (4b), et
le matériau de liaison électriquement conducteur (5) dans la section inactive (4b) est la région plus large (51).

7. L'élément piézoélectrique multicouche (1) selon l'une quelconque des revendications 1 à 6, dans lequel :
une largeur avec la région plus large (51) augmente progressivement au fur et à mesure que l'on s'éloigne des autres régions.

8. Un dispositif d'injection (19), comprenant :
un récipient (23) comprenant un trou d'injection (21), et
l'élément piézoélectrique multicouche (1) selon l'une quelconque des revendications 1 à 7, où
le dispositif d'injection (19) est configuré pour décharger un fluide stocké dans le conteneur (23) à travers le trou d'injection (21) en entraînant l'élément piézoélectrique multicouche (1).

9. Un système d'injection de carburant (35) comprenant :
une rampe commune (37) configurée de manière à stocker un carburant à haute pression,
le dispositif d'injection (8) selon la revendication 8 configuré de manière à injecter le carburant à haute pression stocké dans la rampe commune (37),
une pompe à pression (39) configurée de manière à fournir le carburant à haute pression à la rampe commune (37), et
une unité de contrôle d'injection (41) configurée de manière à émettre des signaux d'entraînement au dispositif d'injection (8).
